# FASCICULE DE BREVET EUROPEEN

(11) **EP 3 568 869 B1**
(45) Date de publication et mention de la délivrance du brevet: **24.02.2021**
(21) Numéro de dépôt: 18702753.7
(22) Date de dépôt: 10.01.2018
(51) Int. Cl.: H01L 21/20, H01L 21/02

(54) **SUBSTRAT POUR CAPTEUR D'IMAGE DE TYPE FACE AVANT ET PROCÉDÉ DE FABRICATION D'UN TEL SUBSTRAT**
SUBSTRAT FÜR EINEN -BILDSENSOR VOM FRONTSEITENTYP UND VERFAHREN ZUR HERSTELLUNG SOLCH EINES SUBSTRATS
SUBSTRATE FOR A FRONT-SIDE-TYPE IMAGE SENSOR AND METHOD FOR PRODUCING SUCH A SUBSTRATE

(30) Priorité: 11.01.2017 FR 1750235
(43) Date de publication de la demande: 20.11.2019
(73) Titulaire: Soitec, 38190 Bernin (FR)
(72) Inventeur: SCHWARZENBACH, Walter, 38330 Saint Nazaire Les Eymes (FR); KONONCHUK, Oleg, 38570 Theys (FR); ECARNOT, Ludovic, 38000 Grenoble (FR); MICHAU, Christelle, 38190 Bernin (FR)
(74) Mandataire: Regimbeau
(86) Numéro de dépôt international: PCT/FR2018/050054
(87) Numéro de publication internationale: WO 2018/130781

(56) Documents cités:
- US-A1- 2008 050 887
- US-A1- 2010 129 948
- US-A1- 2012 068 289

## Description

### DOMAINE DE L'INVENTION

La présente invention concerne un substrat pour capteur d'image de type « face avant », un capteur d'image incorporant un tel substrat, et un procédé de fabrication d'un tel substrat.

### ETAT DE LA TECHNIQUE

Le document US 2016/0118431 décrit un capteur d'image de type « face avant » (« front-side imager », selon la terminologie anglo-saxonne).

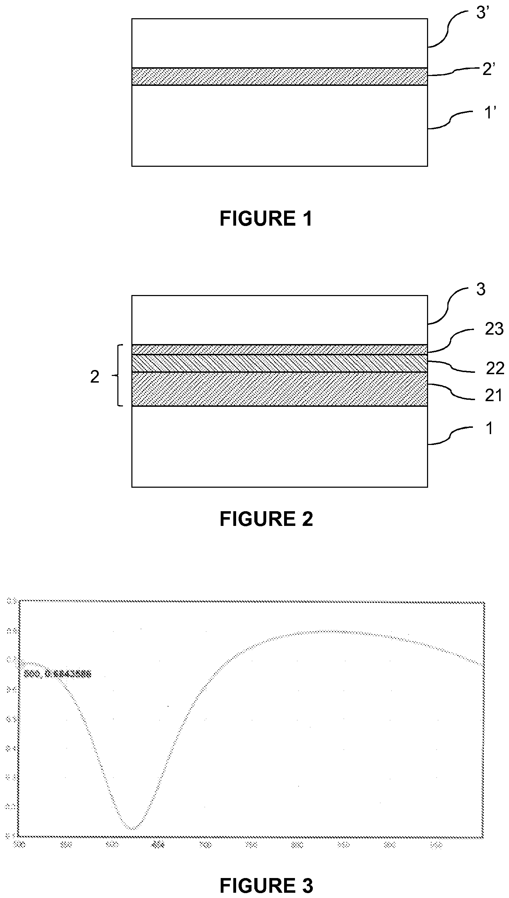

Comme illustré sur la figure 1, ledit capteur comprend un substrat de type semi-conducteur sur isolant (SOI, acronyme du terme anglo-saxon « Semiconductor-On-Insulator ») comprenant, de sa face arrière vers sa face avant, un substrat support 1' de silicium présentant un certain dopage, une couche 2' d'oxyde de silicium dite « couche d'oxyde enterrée » (BOX, acronyme du terme anglo-saxon « Buried OXide »), et une couche 3' dite couche active de silicium présentant un dopage pouvant être différent de celui de la couche support 1', dans laquelle est défini un réseau matriciel de photodiodes définissant chacune un pixel.

Toutefois, un tel capteur présente une faible sensibilité dans le proche infrarouge, c'est-à-dire pour des longueurs d'onde comprises entre 700 nm et 3 µm.

En effet, la couche active de silicium présente un coefficient d'absorption qui décroît fortement avec la longueur d'onde d'un rayonnement auquel elle est exposée, à savoir d'environ 10⁶ cm⁻¹ pour une longueur d'onde de 300 nm à quelques 10³ cm⁻¹ à partir de 700 nm. Le document US2008/0050887 décrit également un substrat pour un capteur d'image.

### EXPOSE DE L'INVENTION

Un but de l'invention est de remédier au problème susmentionné et de proposer un substrat pour capteur d'image de type « face avant » qui permette d'augmenter l'absorption de lumière dans le proche infrarouge.

A cet effet, l'invention propose un substrat pour un capteur d'image de type face avant, comprenant successivement un substrat support semi-conducteur, une couche électriquement isolante et une couche semi-conductrice de silicium-germanium monocristallin dite couche active, caractérisé en ce que la couche électriquement isolante est constituée d'un empilement de couches diélectriques ou d'un empilement de couches diélectriques et métalliques choisies de telle sorte que la réflectivité dudit empilement dans une gamme de longueurs d'onde comprises entre 700 nm et 3 µm soit supérieure à la réflectivité d'une couche d'oxyde de silicium présentant une épaisseur égale à celle dudit empilement, ledit substrat comprenant en outre une couche de silicium monocristallin entre la couche électriquement isolante et la couche active de silicium-germanium.

Par « face avant » on entend dans le présent texte la face du capteur d'image destinée à être exposée à un rayonnement lumineux, qui se trouve du même côté du substrat que les composants électroniques associés.

De manière avantageuse, l'épaisseur de la couche électriquement isolante est comprise entre 10 et 500 nm.

Selon un mode de réalisation, la couche électriquement isolante comprend au moins une couche métallique intercalée entre une première couche diélectrique située à l'interface avec le substrat support et une seconde couche diélectrique située à l'interface avec la couche active.

La couche métallique peut être une couche de nitrure de titane, et les première et seconde couches diélectriques peuvent être des couches d'oxyde de silicium.

Selon un mode de réalisation particulier, l'épaisseur de la première couche d'oxyde de silicium est comprise entre 300 et 500 nm, l'épaisseur de la couche de nitrure de titane est comprise entre 10 et 100 nm, et l'épaisseur de la seconde couche d'oxyde de silicium est comprise entre 10 et 50 nm.

De préférence, la teneur en germanium de la couche active est inférieure ou égale à 10%.

De manière avantageuse, l'épaisseur de la couche active est inférieure à une épaisseur critique de la couche de silicium-germanium définie comme étant une épaisseur au-delà de laquelle une relaxation du silicium-germanium se produit.

L'invention concerne également un capteur d'image face avant comprenant un tel substrat et un réseau matriciel de photodiodes dans la couche active dudit substrat.

Un autre objet de l'invention concerne un procédé de fabrication d'un tel substrat.

Ledit procédé comprend les étapes suivantes :
- fourniture d'un substrat donneur comprenant un matériau semi-conducteur adapté pour former la croissance épitaxiale de la couche active, ledit matériau semi-conducteur étant du silicium monocristallin
- fourniture du substrat support ;
- formation de la couche électriquement isolante par dépôt d'un empilement de couches diélectriques ou d'un empilement de couches diélectriques et métalliques sur le substrat support, lesdites couches diélectriques et/ou métalliques étant choisies de telle sorte que la réflectivité dudit empilement dans une gamme de longueurs d'onde comprises entre 700 nm et 3 µm soit supérieure à la réflectivité d'une couche d'oxyde de silicium présentant une épaisseur égale à celle dudit empilement,
- collage du substrat donneur sur le substrat support, la couche électriquement isolante étant à l'interface de collage ;
- amincissement du substrat donneur de sorte à transférer une couche de silicium monocristallin sur le substrat support,
- croissance épitaxiale, sur la couche de silicium monocristallin transférée, d'une couche semi-conductrice monocristalline de silicium-germanium pour former la couche active.

Selon un mode de réalisation, ledit empilement de couches diélectriques et/ou métalliques déposées sur le substrat support comprend successivement une première couche diélectrique, une couche métallique et une seconde couche diélectrique.

Selon un mode de réalisation, la couche métallique est une couche de nitrure de titane, et les première et seconde couches diélectriques sont des couches d'oxyde de silicium.

De manière avantageuse, l'épaisseur de la première couche d'oxyde de silicium est comprise entre 300 et 500 nm, l'épaisseur de la couche de nitrure de titane est comprise entre 10 et 100 nm, et l'épaisseur de la seconde couche d'oxyde de silicium est comprise entre 10 et 50 nm.

Selon un mode de réalisation préféré, le procédé comprend une étape de formation d'une zone de fragilisation dans le substrat donneur de sorte à délimiter une couche de silicium monocristallin à transférer sur le substrat support, et l'amincissement du substrat donneur comprend un détachement selon ladite zone de fragilisation.

De manière avantageuse, la formation de la zone de fragilisation comprend les étapes suivantes :
- formation d'une couche d'oxyde sacrificielle sur le substrat donneur,
- implantation d'espèces atomiques dans le substrat donneur au travers de ladite couche d'oxyde sacrificielle,
- retrait de ladite couche d'oxyde sacrificielle avant le collage du substrat donneur sur le substrat support.

L'épaisseur de la couche de silicium monocristallin transférée sur le substrat receveur est typiquement inférieure ou égale à 400 nm.

A l'issue de la croissance épitaxiale de silicium-germanium, la couche de silicium monocristallin peut être conservée entre la couche électriquement isolante et la couche de silicium-germanium.

De manière alternative, le procédé peut comprendre en outre une étape de condensation du silicium-germanium de la couche active de sorte à convertir la couche de silicium monocristallin à partir de laquelle la croissance épitaxiale de silicium-germanium a été effectuée en une couche de silicium-germanium.

Selon un autre mode de réalisation, le matériau semi-conducteur du substrat donneur adapté pour la croissance épitaxiale de la couche active est du silicium-germanium.

Ledit matériau semi-conducteur est avantageusement formé par épitaxie sur un substrat de base, ledit matériau semi-conducteur et le substrat de base formant ensemble le substrat donneur.

### DESCRIPTION DES FIGURES

D'autres caractéristiques et avantages de l'invention apparaîtront à la lecture de la description détaillée qui va suivre, en référence aux dessins annexés sur lesquels :
- la figure 1 est une vue en coupe d'un substrat SOI pour capteur d'image face avant tel que décrit dans le document US 2016/0118431 ;
- la figure 2 est une vue en coupe d'un substrat pour capteur d'image face avant dans lequel la couche électriquement isolante est constituée d'un empilement de couches diélectriques et/ou métalliques ;
- la figure 3 illustre la réflectivité d'un empilement de couches diélectriques en fonction de la longueur d'onde (en nm) ;
- les figures 4A-4E illustrent les principales étapes d'un procédé de fabrication du substrat pour capteur d'image face avant selon un mode de réalisation de l'invention ;
- la figure 5 présente le coefficient d'absorption du silicium-germanium en fonction de la longueur d'onde pour différentes teneur en germanium ;
- la figure 6 présente l'épaisseur critique d'une couche de silicium-germanium en fonction de sa teneur en germanium ;
- les figures 7A-7F illustrent les principales étapes d'un procédé de fabrication selon un mode particulier de réalisation dans lequel la couche active est en silicium-germanium ;
- les figures 8A-8C illustrent des étapes d'une variante du procédé de fabrication illustré sur les figures 7A à 7F ;
- la figure 9 est une vue en coupe d'un pixel d'un capteur d'image de type « face avant » comprenant un substrat selon un mode de réalisation de l'invention.

Pour des raisons de lisibilité des figures, les différentes couches ne sont pas nécessairement représentées à l'échelle.

### DESCRIPTION DETAILLEE DE MODES DE REALISATION DE L'INVENTION

La figure 2 est une vue en coupe d'un substrat pour un capteur d'image face avant.

Ledit substrat comprend successivement, de sa face arrière vers sa face avant, un substrat support 1 semi-conducteur, une couche électriquement isolante 2 et une couche 3 semi-conductrice monocristalline dite couche active.

Le substrat support 1 est généralement obtenu par découpe d'un lingot monocristallin. De manière avantageuse, le substrat 1 est en silicium.

La couche 3 est destinée à recevoir un réseau matriciel de photodiodes (non représenté) permettant la capture d'images. L'épaisseur de la couche 3 est typiquement supérieure ou égale à 1 µm. Selon l'invention, la couche 3 est en silicium -germanium monocristallin. Ladite couche 3 peut être légèrement dopée.

La couche électriquement isolante 2 n'est pas, comme dans les substrats SOI conventionnels, une couche d'oxyde de silicium, mais est constituée d'un empilement de couches diélectriques et/ou métalliques choisies de sorte à augmenter la réflectivité de ladite couche électriquement isolante dans l'infrarouge.

Plus précisément, les couches diélectriques et/ou métalliques formant cet empilement sont choisies de telle sorte que la réflectivité dudit empilement dans une gamme de longueurs d'onde comprises entre 700 nm et 3 µm soit supérieure à la réflectivité d'une couche d'oxyde de silicium présentant une épaisseur égale à celle dudit empilement.

Par ailleurs, une couche métallique de l'empilement est avantageusement séparée du substrat support et de la couche active par au moins une couche diélectrique. Lesdites couches diélectriques assurent donc notamment une fonction d'isolation électrique de la couche active vis-à-vis du substrat support.

Par exemple, dans le mode de réalisation illustré sur la figure 2, la couche électriquement isolante 2 comprend successivement :
- une première couche 21 d'oxyde de silicium à l'interface avec le substrat support 1,
- une couche 22 de nitrure de titane, et
- une seconde couche 23 d'oxyde de silicium, à l'interface avec la couche active 3.

Le nitrure de titane est un matériau métallique couramment utilisé en microélectronique.

Les couches diélectriques 21 et 23 d'oxyde de silicium permettent d'encapsuler la couche de nitrure de titane et évitent ainsi toute contamination métallique de la couche active. On évite ainsi la génération de défauts électriques à l'interface entre la couche active et la couche électriquement isolante et des recombinaisons entre le silicium de la couche active et les composants métalliques du capteur, susceptibles de doper la couche active.

Typiquement, la couche 21 présente une épaisseur comprise entre 300 et 500 nm, la couche 23 une épaisseur comprise entre 10 et 50 nm, et la couche 22 une épaisseur comprise entre 10 et 100 nm.

Une telle couche électriquement isolante présente l'avantage de réfléchir davantage les photons transmis au travers de la couche active 3 qu'une couche d'oxyde de silicium d'épaisseur identique.

Ceci est visible sur la figure 3, qui présente la réflectivité de l'empilement suivant (du substrat support vers la couche active) en fonction de la longueur d'onde (en nm) :
- la première couche 21 d'oxyde de silicium, de 400 nm d'épaisseur,
- la couche 22 de nitrure de titane, de 50 nm d'épaisseur, et
- la seconde couche 23 d'oxyde de silicium, de 20 nm d'épaisseur.

On obtient ainsi une réflectivité atteignant 0,8 pour une longueur d'onde de 850 nm. A titre de comparaison, une couche de 400 nm d'oxyde de silicium présente une réflectivité de 0,5 pour une longueur d'onde de 850 nm.

Cette réflectivité accrue a pour effet d'augmenter la longueur du trajet des photons au sein de la couche active 3, et ainsi de favoriser leur absorption par ladite couche.

On va maintenant décrire des exemples de procédés de fabrication du substrat illustré sur la figure 2.

D'une manière générale, le procédé de fabrication d'un substrat selon l'invention, comprend les étapes suivantes.

D'une part, on fournit un substrat donneur comprenant un matériau semi-conducteur adapté pour la croissance épitaxiale du matériau destiné à former la couche active. Selon i'invention, ledit matériau est du silicium monocristallin. De manière alternative, lorsque la couche active doit être réalisée en silicium-germanium (SiGe) comme on le verra plus bas, ledit matériau peut être du silicium-germanium (permettant une homoépitaxie).

D'autre part, on fournit un substrat receveur, et l'on colle le substrat donneur sur le substrat receveur, une couche électriquement isolante étant à l'interface de collage.

On amincit ensuite le substrat donneur de sorte à transférer une couche du matériau semi-conducteur sur le substrat receveur.

Cet amincissement peut être effectué par polissage ou gravure du matériau semi-conducteur de sorte à obtenir l'épaisseur et l'état de surface souhaité pour l'épitaxie du matériau de la couche active.

Toutefois, de manière avantageuse, on procède, avant l'étape de collage, à la formation d'une zone de fragilisation dans le matériau semi-conducteur de sorte à délimiter une couche superficielle à transférer. De manière préférée, la formation de la zone de fragilisation est formée par implantation d'espèces atomiques, telles que de l'hydrogène et/ou de l'hélium, dans le substrat donneur. Après l'étape de collage, l'amincissement consiste à détacher le substrat donneur le long de la zone de fragilisation, ce qui conduit au transfert de la couche superficielle sur le substrat receveur (procédé connu sous le nom de Smart Cut™). L'épaisseur de la couche transférée est typiquement inférieure ou égale à 400 nm. Eventuellement, on effectue un traitement de finition de la surface libre de la couche transférée afin de favoriser la mise en œuvre de l'épitaxie, ce traitement pouvant conduire à amincir la couche transférée.

Dans le cas où l'on met en œuvre une telle implantation dans le substrat donneur, on ne forme pas l'empilement de couches diélectriques et/ou métalliques sur le substrat donneur mais sur le substrat support. En effet, un tel empilement serait trop épais pour l'implantation. En revanche, de manière avantageuse, on forme sur le substrat donneur, avant implantation, une couche d'oxyde de silicium sacrificielle au travers de laquelle on implante les espèces atomiques destinées à former la zone de fragilisation. Ladite couche sacrificielle permet d'éviter l'effet de « channeling » lors de l'implantation. Ladite couche sacrificielle est ensuite retirée du substrat donneur avant le collage de celui-ci au substrat support.

Enfin, on met en œuvre, sur la couche de matériau semi-conducteur transférée, qui sert de couche germe, la croissance épitaxiale du matériau de la couche active jusqu'à l'obtention de l'épaisseur souhaitée pour la couche active.

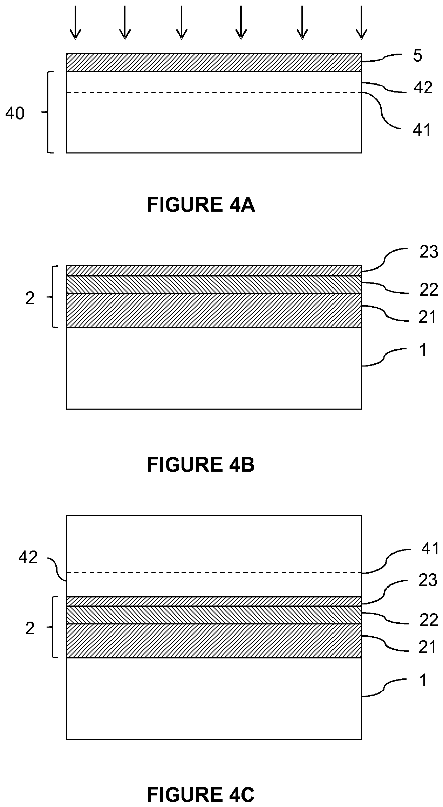

Les figures 4A à 4E illustrent un mode de réalisation préféré d'un substrat pour capteur d'image face avant comprenant un tel empilement de couches diélectriques.

En référence à la figure 4A, on fournit un substrat donneur 40 recouvert d'une couche sacrificielle 5 d'oxyde de silicium, puis l'on forme par implantation d'espèces atomiques au travers de la couche 5 une zone de fragilisation 41 délimitant une couche 42 de silicium à transférer. Après l'implantation, on retire la couche sacrificielle 5, par exemple par gravure chimique.

En référence à la figure 4B, on fournit par ailleurs un substrat receveur, qui est typiquement le substrat support 1 du substrat final, sur lequel on forme l'empilement de couches 21, 22, 23 destinées à former la couche électriquement isolante 2.

En référence à la figure 4C, on colle le substrat donneur 40 sur le substrat support 1, l'empilement de couches diélectriques et/ou métalliques formant la couche électriquement isolante 2 étant à l'interface de collage.

Ensuite, on détache le substrat donneur le long de la zone de fragilisation 41. Ledit détachement peut être initié par toute technique connue de l'homme du métier, telle qu'une contrainte mécanique, chimique, et/ou thermique.

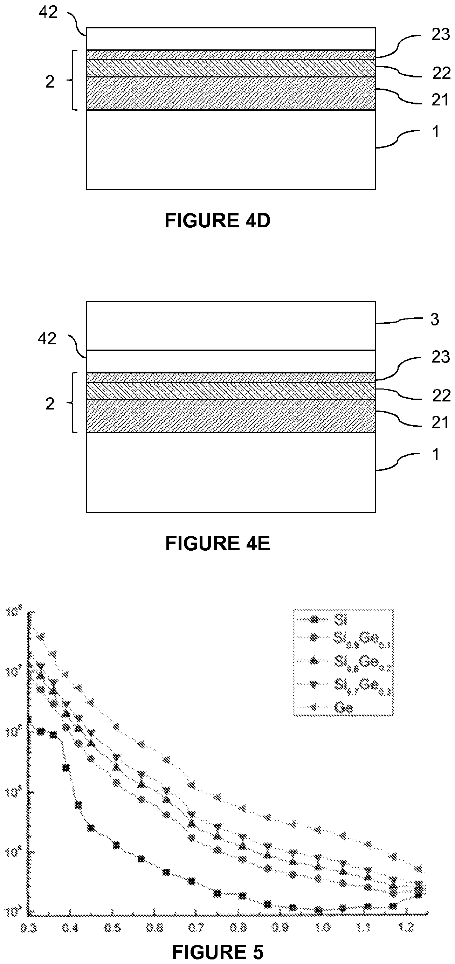

On transfère ainsi la couche 42 du substrat donneur sur le substrat support 1 (cf. figure 4D).

On procède le cas échéant à un traitement de la surface de la couche transférée pour retirer les défauts liés à l'implantation et au détachement, et la rendre suffisamment lisse pour l'étape d'épitaxie qui va suivre.

En référence à la figure 4E, on procède alors à une reprise d'épitaxie du matériau de la couche active sur la couche 42 transférée qui sert de couche germe, jusqu'à l'épaisseur souhaitée pour la couche active 3. Lors de l'épitaxie, il est possible de doper légèrement la couche 3, selon les propriétés électriques souhaitées.

La couche active peut être en silicium monocristallin et la couche transférée servant de couche germe est alors également en silicium monocristallin (homoépitaxie).

Selon l'invention a couche active est en silicium-germanium monocristallin, la couche transférée servant de couche germe pouvant être en silicium monocristallin ou en SiGe monocristallin.

Un avantage particulier du SiGe monocristallin par rapport au silicium monocristallin est sa capacité d'absorption du rayonnement dans le proche infrarouge.

Comme on peut le voir sur la figure 5, qui illustre le coefficient d'absorption (en cm⁻¹) du SiGe en fonction de la longueur d'onde (en µm) pour différentes compositions dudit matériau, le coefficient d'absorption, notamment dans l'infrarouge, augmente avec la teneur en germanium.

Cependant, la conception de la couche 3 ne porte pas que sur la concentration en germanium mais aussi sur l'épaisseur de ladite couche. En effet, la couche de SiGe étant formée par épitaxie sur un substrat de silicium, dont le paramètre de maille est différent de celui du silicium-germanium, il se produit une relaxation de la couche de SiGe au-delà d'une certaine épaisseur, dite épaisseur critique. Cette relaxation se traduit par la formation de dislocations au sein de la couche de SiGe.

De telles dislocations rendraient la couche de SiGe impropre à la fonction de la couche active 3 et doivent donc être évitées.

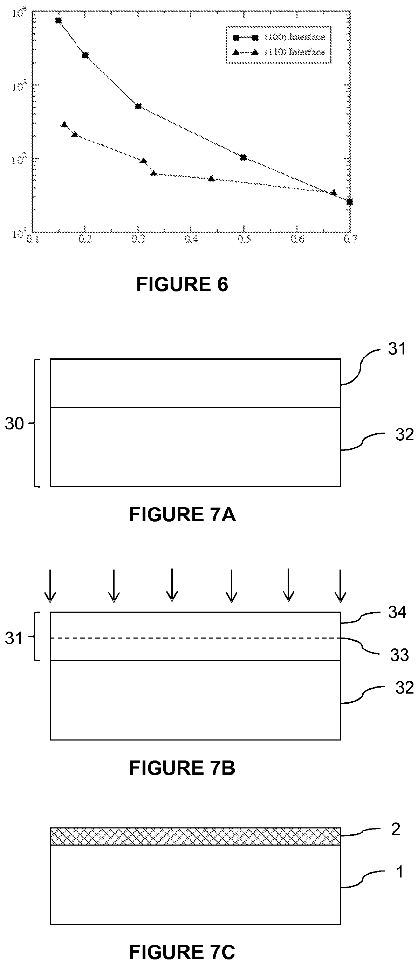

Comme le montre la figure 6, qui illustre l'épaisseur critique (en Å) d'une couche de SiGe en fonction de la teneur en germanium (coefficient stœchiométrique x correspondant à la composition Si₁₋ₓGeₓ), l'épaisseur critique est d'autant plus faible que la concentration en germanium est élevée.

L'épaisseur de la couche active 3 et la concentration en germanium de ladite couche résultent donc d'un compromis entre :
- d'une part, une épaisseur suffisamment grande pour capturer un maximum de photons dans les longueurs d'onde du proche infrarouge,
- d'autre part, une concentration suffisante en germanium pour accroître la capacité d'absorption des photons par la couche active en particulier dans le proche infrarouge, et
- une épaisseur limitée (dépendant de la concentration) pour éviter la relaxation du silicium-germanium et la création de défauts cristallins (dislocations) qui en résulte.

Typiquement, on cherche à maximiser l'épaisseur et la concentration en germanium de la couche 3 pour avoir la meilleure absorption possible dans l'infrarouge,

De préférence, la teneur en germanium de la couche active est inférieure ou égale à 10%. La figure 6 montre en effet que l'épaisseur critique d'une couche de Si_{0,9}Ge_{0,1} est de l'ordre du micromètre, ce qui convient à la couche active d'un capteur d'image de type « face avant ».

Ainsi, avec l'utilisation simultanée de la couche active de silicium-germanium et de l'empilement de couches diélectriques et/ou métalliques formant la couche électriquement isolante, on combine les effets favorables de ces deux couches sur l'absorption du rayonnement infra-rouge.

Par rapport au procédé de fabrication qui vient d'être décrit, le procédé de fabrication d'un substrat dans laquelle la couche active est en SiGe nécessite la fourniture d'un substrat donneur comprenant un matériau semi-conducteur adapté pour la croissance épitaxiale de silicium-germanium. Ledit matériau peut notamment être du SiGe (permettant une homoépitaxie) ou un matériau différent du SiGe mais présentant un paramètre de maille suffisamment proche de celui du SiGe pour permettre la croissance épitaxiale de celui-ci (hétéroépitaxie). Dans ce dernier cas, ledit matériau semi-conducteur est avantageusement du silicium.

On notera que, lorsque la couche germe n'est pas en SiGe, par exemple lorsqu'elle est en silicium, il subsiste, à l'issue de l'épitaxie du SiGe, la couche germe 42 sous la couche active 3.

Cependant, la couche germe est suffisamment mince (d'une épaisseur inférieure ou égale à 300 nm) par rapport à l'épaisseur de la couche active pour ne pas affecter notablement les propriétés de la couche active de SiGe en termes d'absorption dans l'infrarouge.

Cependant, il est possible de retirer la couche germe, par exemple au moyen d'un procédé de condensation. De manière connue en elle-même, ledit procédé comprend une oxydation de la couche de SiGe, ladite oxydation ayant pour effet de consommer uniquement le silicium (pour former de l'oxyde de silicium) et de faire migrer le germanium vers la face opposée à la surface libre de la couche de SiGe. On obtient alors en surface une couche de SiO₂ que l'on peut éliminer par gravure.

Selon un mode de réalisation, illustré sur les figures 7A à 7F, on part d'un substrat donneur 30 comprenant une couche superficielle 31 de SiGe.

Ladite couche de SiGe est typiquement formée par épitaxie sur un substrat de base 32, généralement en silicium. Ladite couche de SiGe est suffisamment mince pour être en contrainte.

Dans une première version de ce mode de réalisation, une zone de fragilisation est formée dans la couche de SiGe.

De manière particulièrement avantageuse, comme illustré sur la figure 7B, ladite zone de fragilisation 33 est formée par implantation d'espèces atomiques (typiquement, de l'hydrogène et/ou de l'hélium) au travers de la surface libre de la couche 31 de SiGe. La zone de fragilisation 33 délimite ainsi une couche 34 de SiGe à la surface du substrat donneur.

En référence à la figure 7C, on fournit par ailleurs un substrat receveur comprenant un substrat support 1 et la couche électriquement isolante 2 constituée de l'empilement de couches diélectriques et/ou métalliques (pour simplifier les dessins, la couche 2 est représentée comme une couche unique, sans distinguer les différentes couches qui la constituent).

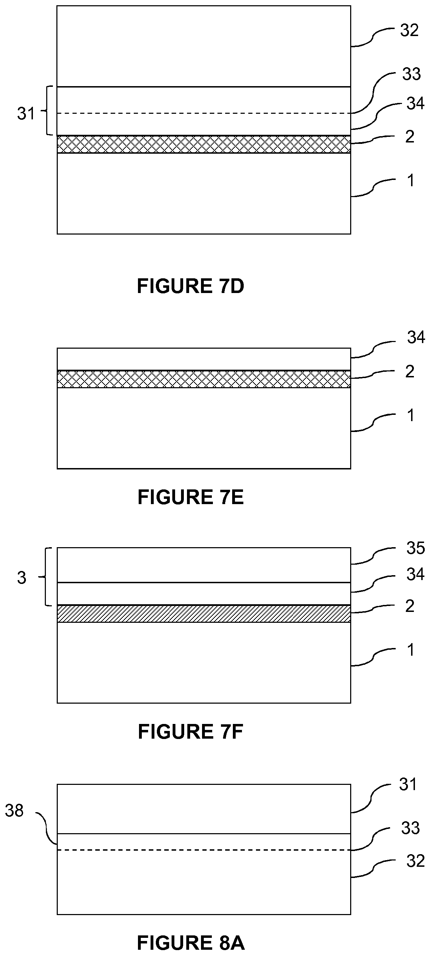

En référence à la figure 7D, on colle le substrat donneur sur le substrat receveur, la couche 31 de SiGe et la couche électriquement isolante 2 étant à l'interface de collage.

Ensuite, comme illustré sur la figure 7E, on détache le substrat donneur le long de la zone de fragilisation. Ledit détachement peut être initié par toute technique connue de l'homme du métier, telle qu'une contrainte mécanique, chimique, et/ou thermique.

On transfère ainsi la couche 34 de SiGe sur le substrat support.

On procède le cas échéant à un traitement de la surface de la couche de SiGe pour retirer les défauts liés à l'implantation et au détachement, et la rendre suffisamment lisse pour l'étape d'épitaxie qui va suivre.

Dans une seconde version de ce mode de réalisation, une zone de fragilisation 33 est formée dans le substrat donneur 30 situé sous la couche 31 de SiGe 31 (cf. figure 8A).

De manière particulièrement avantageuse, ladite zone de fragilisation 33 est formée par implantation d'espèces atomiques (typiquement, de l'hydrogène et/ou de l'hélium) au travers de la surface libre de la couche 30. La zone de fragilisation 33 délimite ainsi une couche de SiGe et d'une portion 38 du substrat de base 32 à la surface du substrat donneur.

En référence à la figure 7C, on fournit par ailleurs un substrat receveur comprenant un substrat support 1 et une couche électriquement isolante 2.

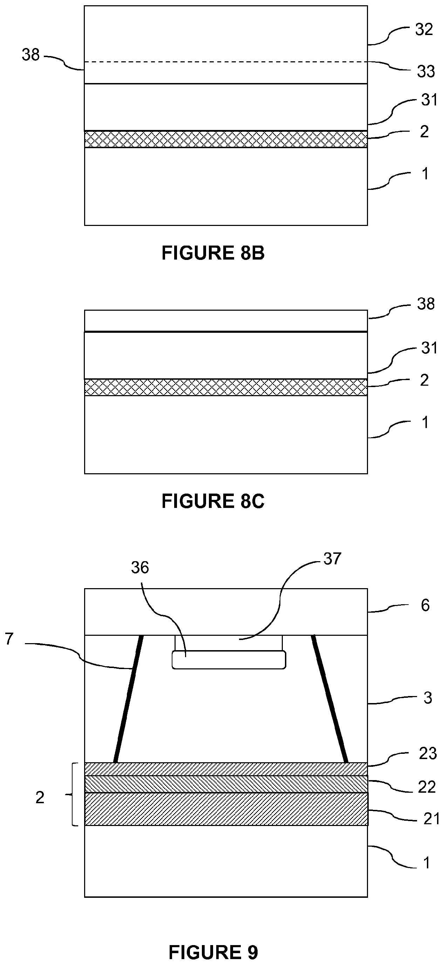

En référence à la figure 8B, on colle le substrat donneur sur le substrat receveur, la couche 31 de SiGe et la couche électriquement isolante 2 étant à l'interface de collage.

Ensuite, on détache le substrat donneur le long de la zone de fragilisation 33. Ledit détachement peut être initié par toute technique connue de l'homme du métier, telle qu'une contrainte mécanique, chimique, et/ou thermique.

On transfère ainsi la couche 31 de SiGe et la portion 38 du substrat de base sur le substrat support (cf. figure 8C).

On procède alors à un traitement de la surface créée pour retirer la portion 38 du substrat donneur superficielle jusqu'à laisser apparaître une surface de SiGe, retirant ainsi les défauts liés à l'implantation et au détachement, et la rendant suffisamment lisse pour l'étape d'épitaxie qui va suivre.

On obtient ainsi, comme sur la figure 7E, une portion 34 de la couche 31 de SiGe sur le substrat support 1.

Comme illustré sur la figure 7F (étape commune aux deux versions du mode de réalisation), on procède alors à une reprise d'épitaxie pour faire croître une couche 35 de SiGe sur la couche 34 transférée qui remplit le rôle de couche germe, jusqu'à l'épaisseur souhaitée pour la couche active 3, qui est formée de l'ensemble des deux couches 34 et 35 de SiGe. Lors de l'épitaxie, il est possible de doper légèrement la couche 35, selon les propriétés électriques souhaitées. Le dopage de la couche 35 n'est pas nécessairement identique à celui de la couche germe 34.

La figure 9 illustre une partie d'un capteur d'image de type face avant comprenant un substrat selon un mode de réalisation de l'invention. Seule une partie du capteur correspondant à un pixel est représentée sur cette figure, ledit pixel étant isolé électriquement des autres pixels formés dans la couche active 3 par des tranchées d'isolation 7.

Une région 36 dopée de type différent de celui de la couche 3 est formée sous la surface de la face avant de la couche active 3. Cette région 36 forme avec la couche active 3 une photodiode. Une région 37 formée entre la région 36 et la face avant de la couche 3 présente avantageusement un niveau de dopage supérieur à celui de la région 36 afin de passiver l'interface. Une couche de passivation 6 est formée sur la couche active 3 et peut encapsuler des éléments permettant de contrôler électriquement ledit pixel.

Eventuellement, d'autres couches, tels que des filtres, peuvent être formées sur la couche de passivation 6, mais elles ne sont pas représentées sur la figure 9.

La structure du capteur d'image en tant que tel et son procédé de fabrication sont connus de l'homme du métier et ne seront donc pas décrits en détail ici.

### REFERENCES

US 2016/0118431

## Revendications

1. Substrat pour un capteur d'image de type face avant, comprenant successivement un substrat support (1) semi-conducteur, une couche électriquement isolante (2) et une couche (3) semi-conductrice de silicium-germanium monocristallin dite couche active, **caractérisé en ce que** la couche électriquement isolante est constituée d'un empilement de couches diélectriques ou d'un empilement de couches diélectriques et métalliques (21, 22, 23) choisies de telle sorte que la réflectivité dudit empilement dans une gamme de longueurs d'onde comprises entre 700 nm et 3 µm soit supérieure à la réflectivité d'une couche d'oxyde de silicium présentant une épaisseur égale à celle dudit empilement, ledit substrat comprenant en outre une couche de silicium monocristallin (42) entre la couche électriquement isolante (2) et la couche active (3) de silicium-germanium.

2. Substrat selon la revendication 1, dans lequel l'épaisseur de la couche électriquement isolante (2) est comprise entre 10 et 500 nm.

3. Substrat selon l'une des revendications 1 ou 2, dans lequel la couche électriquement isolante (2) comprend au moins une couche (22) métallique intercalée entre une première couche (21) diélectrique située à l'interface avec le substrat support (1) et une seconde couche (23) diélectrique située à l'interface avec la couche active (3).

4. Substrat selon la revendication 3, dans lequel la couche (22) métallique est une couche de nitrure de titane, et les première et seconde couches diélectriques (21, 23) sont des couches d'oxyde de silicium.

5. Substrat selon la revendication 4, dans lequel l'épaisseur de la première couche (21) d'oxyde de silicium est comprise entre 300 et 500 nm, l'épaisseur de la couche (22) de nitrure de titane est comprise entre 10 et 100 nm, et l'épaisseur de la seconde couche (23) d'oxyde de silicium est comprise entre 10 et 50 nm.

6. Substrat selon l'une des revendications 1 à 5, dans lequel la teneur en germanium de la couche active (3) est inférieure ou égale à 10%.

7. Substrat selon l'une des revendications 1 à 6, dans lequel l'épaisseur de la couche active (3) est inférieure à une épaisseur critique de la couche de silicium-germanium définie comme étant une épaisseur au-delà de laquelle une relaxation du silicium-germanium se produit.

8. Capteur d'image de type face avant, **caractérisé en ce qu'**il comprend un substrat selon l'une des revendications 1 à 7 et un réseau matriciel de photodiodes dans la couche active (3) dudit substrat.

9. Procédé de fabrication d'un substrat pour un capteur d'image de type face avant comprenant successivement un substrat support (1) semi-conducteur, une couche électriquement isolante (2) et une couche (3) semi-conductrice monocristalline de silicium-germanium dite couche active, ledit procédé comprenant les étapes suivantes :
- fourniture d'un substrat donneur (30, 40) comprenant un matériau semi-conducteur adapté pour former la croissance épitaxiale de la couche active (3), ledit matériau semi-conducteur étant du silicium monocristallin ;
- fourniture du substrat support (1) ;
- formation de la couche électriquement isolante (2) par dépôt d'un empilement de couches diélectriques ou d'un empilement de couches diélectriques et métalliques (21, 22, 23) sur le substrat support (1), lesdites couches diélectriques et/ou métalliques étant choisies de telle sorte que la réflectivité dudit empilement dans une gamme de longueurs d'onde comprises entre 700 nm et 3 µm soit supérieure à la réflectivité d'une couche d'oxyde de silicium présentant une épaisseur égale à celle dudit empilement,
- collage du substrat donneur sur le substrat support (1), la couche électriquement isolante (2) étant à l'interface de collage ;
- amincissement du substrat donneur de sorte à transférer une couche (34, 42) de silicium monocristallin sur le substrat support (1),
- croissance épitaxiale, sur la couche (34, 42) de silicium monocristallin transférée, d'une couche semi-conductrice monocristalline de silicium-germanium pour former la couche active (3).

10. Procédé selon la revendication 9, dans lequel ledit empilement de couches diélectriques et/ou métalliques (21, 22, 23) déposées sur le substrat support (1) comprend successivement une première couche (21) diélectrique, une couche (22) métallique et une seconde couche (23) diélectrique.

11. Procédé selon la revendication 10, dans lequel la couche (22) métallique est une couche de nitrure de titane, et les première et seconde couches diélectriques (21, 23) sont des couches d'oxyde de silicium.

12. Procédé selon la revendication 11, dans lequel l'épaisseur de la première couche (21) d'oxyde de silicium est comprise entre 300 et 500 nm, l'épaisseur de la couche (22) de nitrure de titane est comprise entre 10 et 100 nm, et l'épaisseur de la seconde couche (23) d'oxyde de silicium est comprise entre 10 et 50 nm.

13. Procédé selon l'une des revendications 9 à 12, comprenant une étape de formation d'une zone de fragilisation (33, 41) dans le substrat donneur (30, 40) de sorte à délimiter une couche de silicium monocristallin à transférer sur le substrat support, et dans lequel l'amincissement du substrat donneur comprend un détachement selon ladite zone de fragilisation.

14. Procédé selon la revendication 13, dans lequel la formation de la zone de fragilisation comprend les étapes suivantes :
- formation d'une couche d'oxyde sacrificielle (5) sur le substrat donneur (40),
- implantation d'espèces atomiques dans le substrat donneur au travers de ladite couche d'oxyde sacrificielle (5),
- retrait de ladite couche d'oxyde sacrificielle (5) avant le collage du substrat donneur sur le substrat support.

15. Procédé selon l'une des revendications 9 à 14, dans lequel l'épaisseur de la couche de silicium monocristallin transférée sur le substrat receveur est inférieure ou égale à 400 nm.

16. Procédé selon l'une des revendications 9 à 15, dans lequel, à l'issue de la croissance épitaxiale de silicium-germanium, la couche de silicium monocristallin (42) est conservée entre la couche électriquement isolante (2) et la couche (3) de silicium-germanium.

17. Procédé selon l'une des revendications 9 à 15, comprenant en outre une étape de condensation du silicium-germanium de la couche active (3) de sorte à convertir la couche de silicium monocristallin à partir de laquelle la croissance épitaxiale de silicium-germanium a été effectuée en une couche de silicium-germanium.

## Patentansprüche

1. Substrat für einen Bildabtaster vom Typ Vorderseite, umfassend sukzessive ein Halbleiter-Trägersubstrat (1), eine elektrisch isolierende Schicht (2) und eine Halbleiterschicht aus monokristallinem Silizium-Germanium (3), die als aktive Schicht bezeichnet ist, **dadurch gekennzeichnet, dass** die elektrisch isolierende Schicht aus einer Stapelung von dielektrischen Schichten oder einer Stapelung von dielektrischen und metallischen Schichten (21, 22, 23) gebildet ist, die derart ausgewählt sind, dass die Reflektivität der genannten Stapelung in einem Wellenlängenbereich, der zwischen 700 nm und 3 µm inbegriffen ist, größer ist als die Reflektivität einer Siliziumoxid-Schicht, die eine Dicke aufweist, die gleich der der genannten Stapelung ist, wobei das genannte Substrat darüber hinaus eine monokristalline Siliziumschicht (42) zwischen der elektrisch isolierenden Schicht (2) und der aktiven Silizium-Germaniumschicht umfasst.

2. Substrat gemäß Anspruch 1, bei dem die Dicke der elektrisch isolierenden Schicht (2) zwischen 10 und 500 nm inbegriffen ist.

3. Substrat gemäß einem der Ansprüche 1 oder 2, bei dem die elektrisch isolierende Schicht (2) wenigstens eine metallische Schicht (22) umfasst, die zwischen einer ersten dielektrischen Schicht (21), die an der Schnittstelle mit dem Trägersubstrat (1) angeordnet ist, und einer zweiten dielektrischen Schicht (23), die an der Schnittstelle mit der aktiven Schicht (3) angeordnet ist, zwischengeschaltet ist.

4. Substrat gemäß Anspruch 3, bei dem die metallische Schicht (22) eine Titannitrid-Schicht ist und die erste und die zweite dielektrische Schicht (21, 23) Siliziumoxid-Schichten sind.

5. Substrat gemäß Anspruch 4, bei dem die Dicke der ersten Siliziumoxid-Schicht (21) zwischen 300 und 500 nm inbegriffen ist, die Dicke der Titannitrid-Schicht (22) zwischen 10 und 100 nm inbegriffen ist und die Dicke der zweiten Siliziumoxid-Schicht zwischen 10 und 50 nm inbegriffen ist.

6. Substrat gemäß einem der Ansprüche 1 bis 5, bei dem der Gehalt an Germanium der aktiven Schicht (3) geringer als oder gleich 10 % ist.

7. Substrat gemäß einem der Ansprüche 1 bis 6, bei dem die Dicke der aktiven Schicht (3) geringer ist als eine kritische Dicke der Silizium-Germaniumschicht, die als eine Dicke definiert ist, über die hinaus eine Entspannung des Siliziums-Germaniums erfolgt.

8. Bildabtaster vom Typ Vorderseite, **dadurch gekennzeichnet, dass** er ein Substrat gemäß einem der Ansprüche 1 bis 7 und ein Matrixnetz aus Fotodioden in der aktiven Schicht (3) des genannten Substrats umfasst.

9. Herstellungsverfahren eines Substrats für einen Bildsensor vom Typ Vorderseite, umfassend sukzessive ein Halbleiter-Trägersubstrat (1), eine elektrisch isolierende Schicht (2) und eine monokristalline Halbleiterschicht aus Silizium-Germanium, bezeichnet als aktive Schicht, wobei das genannte Verfahren die folgenden Schritte umfasst:
- Bereitstellung eines Spendersubstrats (30, 40), umfassend ein Halbleitermaterial, das zum Bilden des epitaxialen Wachstums der aktiven Schicht (3) geeignet ist, wobei das genannte Halbleitermaterial monokristallines Silizium ist;
- Bereitstellung des Trägersubstrats (1);
- Bildung der elektrisch isolierenden Schicht (2) per Aufbringen einer Stapelung aus dielektrischen Schichten oder einer Stapelung aus dielektrischen und metallischen Schichten (21, 22, 23) auf dem Trägersubstrat (1), wobei die genannten dielektrischen und / oder metallischen Schichten derart ausgewählt sind, dass die Reflektivität der genannten Stapelung in einem Wellenlängen-Bereich, der zwischen 700 nm und 3 µm inbegriffen ist, größer ist als die Reflektivität einer Siliziumoxid-Schicht, die eine Dicke aufweist, die gleich der der genannten Stapelung ist;
- Verkleben des Spendersubstrats auf dem Trägersubstrat (1), wobei die elektrisch isolierende Schicht (2) an der Verklebungsschnittstelle angeordnet ist;
- Ausdünnen des Spendersubstrats derart, dass eine monokristalline Siliziumschicht (34, 42) auf das Trägersubstrat (1) übertragen wird,
- epitaxiales Wachstum einer monokristallinen Halbleiterschicht aus Silizium-Germanium auf der übertragenen monokristallinen Siliziumschicht (34, 42) zum Bilden der aktiven Schicht.

10. Verfahren gemäß Anspruch 9, bei dem die genannte Stapelung aus dielektrischen und / oder metallischen Schichten (21, 22, 23), die auf dem Trägersubstrat (1) aufgebracht werden, sukzessive eine erste dielektrische Schicht (21), eine metallische Schicht (22) und eine zweite dielektrische Schicht (23) umfasst.

11. Verfahren gemäß Anspruch 10, bei dem die metallische Schicht (22) eine Titannitrid-Schicht ist und die erste und die zweite dielektrische Schicht (21, 23) Siliziumoxid-Schichten sind.

12. Verfahren gemäß Anspruch 11, bei dem die Dicke der ersten Siliziumoxid-Schicht (21) zwischen 300 und 500 nm inbegriffen ist, die Dicke der Titannitrid-Schicht (22) zwischen 10 und 100 nm inbegriffen ist und die Dicke der zweiten Siliziumoxid-Schicht (23) zwischen 10 und 50 nm inbegriffen ist.

13. Verfahren gemäß einem der Ansprüche 9 bis 12, umfassend einen Bildungsschritt einer Bruchzone (33, 41) in dem Spendersubstrat (30, 40) derart, dass eine auf das Trägersubstrat zu übertragende monokristalline Siliziumschicht begrenzt wird und bei dem das Ausdünnen des Spendersubstrats ein Ablösen gemäß der genannten Bruchzone umfasst.

14. Verfahren gemäß Anspruch 13, bei dem die Bildung der Bruchzone die folgenden Schritte umfasst:
- Bildung einer Opferschicht (5) auf dem Spendersubstrat (40),
- Einsetzen von atomaren Sorten in das Spendersubstrat durch die genannte Opfer-Oxidschicht (5),
- Abnehmen der genannten Opfer-Oxidschicht (5) vor dem Verkleben des Spendersubstrats auf dem Trägersubstrat.

15. Verfahren gemäß einem der Ansprüche 9 bis 14, bei dem die Dicke der auf das Empfängersubstrat übertragenen monokristallinen Siliziumschicht geringer als oder gleich 400 nm ist.

16. Verfahren gemäß einem der Ansprüche 9 bis 15, bei dem die monokristalline Siliziumschicht (42) nach Ablauf des epitaxialen Wachstums des Siliziums-Germaniums zwischen der elektrisch isolierenden Schicht (2) und der Silizium-Germaniumschicht beibehalten wird.

17. Verfahren gemäß einem der Ansprüche 9 bis 15, umfassend darüber hinaus einen Kondensierungsschritt des Siliziums-Germaniums der aktiven Schicht (3) derart, dass die monokristalline Siliziumschicht, aus der das epitaxiale Wachstum des Siliziums-Germaniums ausgeführt wurde, in eine Silizium-Germaniumschicht umgewandelt wird.

## Claims

1. Substrate for a front side type imager, successively comprising a semiconductor support substrate (1), an electrically insulating layer (2) and a silicon-germanium semiconductor layer (3) called active layer, **characterised in that** the electrically insulating layer is constituted of a stack of dielectric layers or a stack of dielectric and metal layers (21, 22, 23) chosen in such a way that the reflectivity of said stack in a range of wavelengths comprised between 700 nm and 3 µm is greater than the reflectivity of a silicon oxide layer having a thickness equal to that of said stack, said substrate further comprising a single crystal silicon layer (42) between the electrically insulating layer (2) and the active silicon-germanium layer (3).

2. Substrate according to claim 1, wherein the thickness of the electrically insulating layer (2) is comprised between 10 and 500 nm.

3. Substrate according to one of claims 1 or 2, wherein the electrically insulating layer (2) comprises at least one metal layer (22) intercalated between a first dielectric layer (21) situated at the interface with the support substrate (1) and a second dielectric layer (23) situated at the interface with the active layer (3).

4. Substrate according to claim 3, wherein the metal layer (22) is a titanium nitride layer, and the first and second dielectric layers (21, 23) are silicon oxide layers.

5. Substrate according to claim 4, wherein the thickness of the first silicon oxide layer (21) is comprised between 300 and 500 nm, the thickness of the titanium nitride layer (22) is comprised between 10 and 100 nm, and the thickness of the second silicon oxide layer (23) is comprised between 10 and 50 nm.

6. Substrate according to one of claims 1 to 5, wherein the germanium content of the active layer (3) is less than or equal to 10%.

7. Substrate according to one of claims 1 to 6, wherein the thickness of the active layer (3) is less than a critical thickness of the silicon-germanium layer defined as being a thickness beyond which silicon-germanium relaxation takes place.

8. Front side type imager, **characterised in that** it comprises a substrate according to one of claims 1 to 7 and a matrix array of photodiodes in the active layer (3) of said substrate.

9. Method of manufacturing a substrate for a front side type imager successively comprising a semiconductor support substrate (1), an electrically insulating layer (2) and a single crystal silicon-germanium semiconductor layer (3) called active layer, said method comprising the following steps:
- provision of a donor substrate (30, 40) comprising a semiconductor material suitable to form the epitaxial growth of the active layer (3), said semiconductor material being single crystal silicon;
- provision of the support substrate (1);
- formation of the electrically insulating layer (2) by deposition of a stack of dielectric layers or a stack of dielectric and metal layers (21, 22, 23) on the support substrate (1), said dielectric and/or metal layers being chosen in such a way that the reflectivity of said stack in a range of wavelengths comprised between 700 nm and 3 µm is greater than the reflectivity of a silicon oxide layer having a thickness equal to that of said stack;
- bonding of the donor substrate on the support substrate (1), the electrically insulating layer (2) being at the bonding interface;
- thinning of the donor substrate so as to transfer a single crystal silicon layer (34, 42) onto the support substrate (1),
- epitaxial growth, on the transferred silicon layer (34, 42), of a monocrystalline silicon-germanium semiconductor layer to form the active layer (3).

10. Method according to claim 9, wherein said stack of dielectric and/or metal layers (21, 22, 23) deposited on the support substrate (1) successively comprises a first dielectric layer (21), a metal layer (22) and a second dielectric layer (23).

11. Method according to claim 10, wherein the metal layer (22) is a titanium nitride layer, and the first and second dielectric layers (21, 23) are silicon oxide layers.

12. Method according to claim 11, wherein the thickness of the first silicon oxide layer (21) is comprised between 300 and 500 nm, the thickness of the titanium nitride layer (22) is comprised between 10 and 100 nm, and the thickness of the second silicon oxide layer (23) is comprised between 10 and 50 nm.

13. Method according to one of claims 9 to 12, comprising a step of formation of an embrittlement zone (33, 41) in the donor substrate (30, 40) so as to delimit a layer of the single crystal silicon to transfer onto the support substrate, and wherein the thinning of the donor substrate comprises a detachment along said embrittlement zone.

14. Method according to claim 13, wherein the formation of the embrittlement zone comprises the following steps:
- formation of a sacrificial oxide layer (5) on the donor substrate (40),
- implantation of atomic species in the donor substrate through said sacrificial oxide layer (5),
- removal of said sacrificial oxide layer (5) before the bonding of the donor substrate on the support substrate.

15. Method according to one of claims 9 to 14, wherein the thickness of the single crystal silicon layer transferred onto the receiver substrate is less than or equal to 400 nm.

16. Method according to one of claims 9 to 15, wherein, at the end of the epitaxial growth of silicon-germanium, the single crystal silicon layer (42) is conserved between the electrically insulating layer (2) and the silicon-germanium layer (3).

17. Method according to one of claims 9 to 15, further comprising a step of condensation of the silicon-germanium of the active layer (3) so as to convert the single crystal silicon layer from which the epitaxial growth of silicon-germanium has been carried out into a silicon-germanium layer.
